# EUROPÄISCHE PATENTSCHRIFT

(11) **EP 0 344 793 B1**
(45) Veröffentlichungstag und Bekanntmachung des Hinweises auf die Patenterteilung: **03.01.1996**
(21) Anmeldenummer: 89109968.1
(22) Anmeldetag: 01.06.1989
(51) Int. Cl.: H05K 13/04

(54) **Gerät zum Bestücken und/oder Verlöten bzw. Verkleben von elektronischen Bauelementen, insbesondere SMD-Bauelementen auf Leiterplatten**
Device for mounting and/or soldering or gluing electronic components, particularly SMD-components on printed circuit boards
Dispositif de montage et/ou de soudage ou de collage de composants électroniques, notamment de composants SMD sur circuits imprimés

(30) Priorität: 03.06.1988 DE 3818889
(43) Veröffentlichungstag der Anmeldung: 06.12.1989
(73) Patentinhaber: Fritsch, Markus, D-92280 Kastl (DE)
(72) Erfinder: Fritsch, Adalbert, verstorben (DE)
(74) Vertreter: Schmidt-Evers, Jürgen, Dipl.-Ing.

(56) Entgegenhaltungen:
- DE-U- 8 800 058
- FR-A- 2 519 833
- GB-A- 2 191 963

## Beschreibung

Die Erfindung bezieht sich auf ein Gerät nach dem Oberbegriff des Anspruchs 1.

Es ist bekannt, Leiterplatten mittels Greifgliedern automatisch zu bestücken, wobei die Greifglieder die Bauelemente computergesteuert von einer Aufnahmeposition aufnehmen, über die Leiterplatte fahren und das Bauelement am Bestückungsort auf der Leiterplatte absetzen. Diese Technik ist verhältnismäßig kompliziert sowie teuer, und zwar insbesondere dann, wenn Bauelemente unterschiedlicher Größen und Formen mit ein und denselben Greifgliedern gehandhabt werden sollen. Zum Bestücken von sogenannten SMD-(small mounted device)-Bauelementen sind solche automatischen Bestückungsgeräte auch aus funktionellen Gründen kaum geeignet, da ein sicheres Ergreifen der kleinen Bauelemente sehr erschwert ist.

Bekannt sind ferner Bestückungstische, bei denen die zu bestückende Leiterplatte über der Tischplatte angeordnet wird und die Bauelemente mittels eines manuell zu verstellenden Bestückungskopfes mit einem Bestückungswerkzeug zwischen einem Magazin und dem jeweiligen Bestückungsort auf der Leiterplatte transportiert werden. Insbesondere, wenn SMD-Bauelemente auf die Leiterplatte aufgesetzt werden sollen, dient für den Bauelemententransport zwischen dem Magazin, beispielswiese eine Griffschale, und dem Bestückungsort auf der Leiterplatte ein Sauggriffel bzw. eine Saugnadel, die in der Ebene der Leiterplatte sowie quer dazu verstellbar ist. Hierdurch ist es möglich, mit der Saugnadel ein Bauelement aus der Griffschale zu entnehmen, zum Bestückungsort zu bewegen und dort abzusetzen. Der die Saugnadel tragende Bestückungskopf ist in zwei horizontalen und einer vertikalen Führung von Hand frei verstellbar, so daß jede Stelle auf der Leiterplatte erreicht werden kann. Eine solche Ausgestaltung ist im DE-GM 88 00 058 beschrieben und dargestellt.

Um das Finden des richtigen Bestückungsortes zu erleichtern, ist es bei anderen bekannten Bestückungstischen schon bekannt, den richtigen Bestückungsort optisch anzuzeigen,, z.B. mittels eines von einem optischen Anzeigesystem erzeugten Lichtstrahls, der auf der Leiterplatte einen Lichtpunkt darstellt. Dabei kann das optische Anzeigesystem durch eine elektronische Steuerschaltung so gesteuert sein, daß beim Bestückungsvorgang einander folgende Bestückungsorte automatisch angezeigt werden.

Bei der manuellen Bestückung hat die Bedienungsperson somit zwei Forderungen zu erfüllen, nämlich zum einen die Lokalisierung des Bestückungsortes auf der Leiterplatte und zum anderen die Zentrierung des Bauelementes am Bestückungsort. Hierzu wird der Bedienungsperson eine hohe Aufmerksamkeit abverlangt, woraus eine beträchtliche Arbeitsbelastung der Bedienungsperson resultiert. Dabei läßt sich auch bei großer Aufmerksamkeit die Gefahr einer Fehlbestückung nicht ausschließen, und zwar insbesondere bei der Bestückung von SMD-Bauelementen, bei denen aufgrund der kleinen Bauweise die Bestückungsorte dicht beieinander liegen.

Ein Gerät der eingangs angegebenen Art ist in der FR-A-2 519 833 beschrieben. Bei diesem bekannten Gerät ist eine dem zweiten Träger für das Bauelement zugeordnete Positioniereinrichtung vorgesehen, die es ermöglicht den zweiten Träger genau über dem gewünschten Bestückungsort auf der Leiterplatte zu positionieren. Bei dieser bekannten Ausgestaltung weist die Positioniervorrichtung mehrere Positionierteile auf, die in einem gewünschten Bestückungsorten entsprechenden Muster ortsfest angeordnet sind. Der zweite Träger für das Bauelement ist mit einem Positionierelement verbunden, das mit einem gewünschten der vorhandenen Positionierteile in Wirkverbindung bringbar ist, wodurch der zweite Träger aufgrund seiner Verbindung mit dem Positionierelement automatisch zum gewünschten Bestückungsort mitbewegt wird. Bei dieser bekannten Ausgestaltung sind die erreichbaren Bestückungsorte auf die Positionen der vorhandenen Positionierteile beschränkt.

Der Erfindung liegt die Aufgabe zugrunde, ein Gerät der eingangs bezeichneten Art so auszugestalten, daß wahlweise Bestückungsorte auf der Leiterplatte leicht gefunden werden können.

Diese Aufgabe wird durch die Merkmale des Anspruchs 1 gelöst.

Bei der erfindungsgemäßen Ausgestaltung sind dem zweiten Träger für das jeweils zu bestückende Bauelement zwei Positionierglieder zugeordnet, von denen das eine, nämlich das Positionierelement, ein Teil des Trägers bzw. von diesem gehalten ist und das andere, nämlich das Positionierteil, relativ zum zweiten Träger bzw. zur Leiterplatte und parallel zur Ebene der Leiterplatte verstellbar ist und zwar jeweils derart verstellbar und feststellbar, daß das Positionierteil im oder in einem betimmten Bezug zum Bestückungsort steht. Es ist somit lediglich erforderlich, das Positonierelement des zweiten Trägers in Wirkkontakt mit dem Positionierteil zu bringen, wodurch der zweite Träger zum Bestückungsort gelangt, in dem das Bauteil auf die Leiterplatte abgesetzt werden kann. Bei der erfindungsgemäßen Ausgestaltung läßt sich deshalb nicht nur der Bestückungsort sicher und leicht finden, sondern es ergibt sich aufgrund der Wirkverbindung zwischen den Positioniergliedern auch eine Zentrierung des zweiten Trägers für das Bauelement im Positionierort, so daß unbeabsichtigte Verstellungen des zweiten Trägers und somit Fehlbestückungen vermieden sind.

Vorteilhafte Weiterbildungen der Erfindung, die aus Gründen einfacher und kostengünstig herstellbarer Bauweise, Funktionssicherheit und Bedienungsfreundlichkeit von Vorteil sind, sind in den Unteransprüchen beschrieben.

Einer besonderen Hervorhebung bedarf die Ausgestaltung nach Anspruch 18, die sich auf eine vorteilhafte Maßnahme zum Zentrieren des jeweils vom zweiten Träger aufgenommenen Bauelements gegenüber dem Bauelement bezieht. Mit dieser Maßnahme läßt sich auf einfache Weise an einer Zwischenstation das Bauelement gegenüber dem zweiten Träger zentrieren, wodurch die Bestückung einfacher, übersichtlicher und präziser durchgeführt werden kann.

Eine Zentrierung der Bauelemente gegenüber ihrem Träger ist auch dann von Vorteil, wenn der Bestückungsort jeweils durch eine besondere Anzeige erkenntlich gemacht wird, z.B. mittels eines Lichtpunktes, wie es eingangs beschrieben worden ist.

Nachfolgend wird die Erfindung anhand von in einer Zeichnung dargestellten bevorzugten Ausführungsbeispielen näher erläutert. Es zeigt:

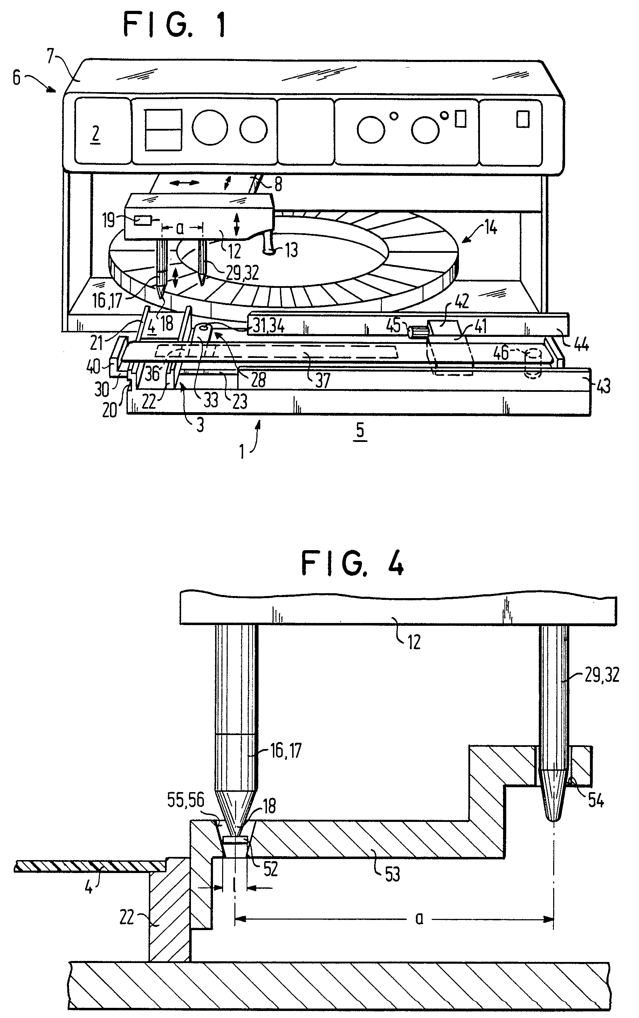

- Fig. 1: ein erfindungsgemäßes Gerät zum Bestücken und/oder Verlöten bzw. Verkleben von elektronischen Bauelementen, insbesondere SMD-Bauelementen, auf Leiterplatten in perspektivischer Vorderansicht;
- Fig. 2: eine Positioniereinrichtung für den Träger für die Bauelemente in der Draufsicht;
- Fig. 3: eine abgewandelte Positioniereinrichtung;
- Fig. 4: den Schnitt IV-IV in Fig. 3.

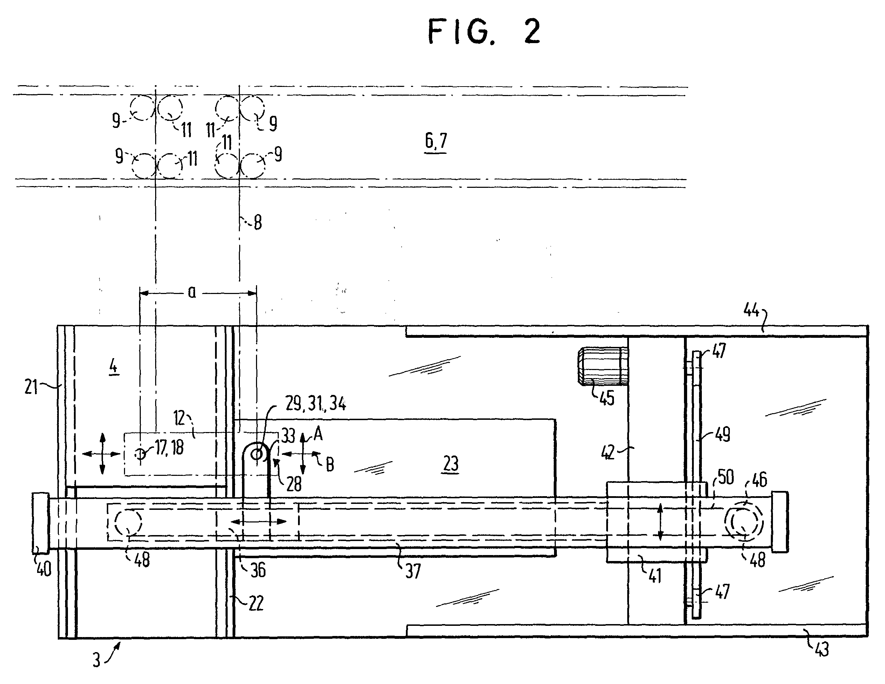

Die wesentlichen Teile des allgemein mit 1 bezeichneten Gerätes in Form eines Manipulators sind ein Halterahmen 3 für Leiterplatten 4, der bezüglich der Bedienungsseite 5 des Gerätes 1 vorn angeordnet ist, ein bezüglich des Halterahmens 3 zur Rückseite hin versetztes, sich parallel zur Bedienungsseite 5 erstreckendes brückenförmiges Führungsteil 6, an dessen waagerechtem Holm 7 unterseitig ein Arm 8 in einer in Fig. 2 andeutungsweise dargestellten Kreuzführung in Form einer angedeuteten Schieber- oder Rollenführung 9,11 im wesentlichen rechtwinklig zur Bedienungsseite 5 und parallel zur Bedienungsseite 5 verschiebbar gelagert ist, ein sogenannter Bestückungskopf 12, der am zur Bedienungsseite 5 weisenden Ende des Armes 8 angeordnet ist mit einem Griff 13, den die Bedienungsperson zwecks wahlweiser Verschiebung des Armes 8 parallel zur Ebene der Leiterplatte 4 ergreift, und ein beim vorliegenden Ausführungsbeispiel rundes Magazin 14 für elektronische Bauelemente, das unter dem Führungsteil 6 angeordnet und vorzugsweise drehbar gelagert ist.

An der Frontseite des Holmes 7 sind die Funktion des Gerätes bestimmende Steuerelemente angeordnet.

Der am Arm 8 vertikal verschiebbar (Doppelpfeil) geführte Bestückungskopf 12 trägt ein von ihm nach unten ragendes allgemein mit 16 bezeichnetes Bestückungs- bzw. Haltewerkzeug mit einer Saugnadel 17 und mit einer an ihrem unteren Ende angeordneten Saugspitze 18, die beim Auftreffen auf ein Hindernis in die Saugnadel 17 bzw. in den Bestückungskopf 12 hineinschiebbar ist. Beim Hineinschieben wird ein im Bestückungskopf 12 befindlicher, andeutungsweise dargestellter Näherungsschalter 19 betätigt, der normalerweise dazu dient, eine nicht dargestellte Unterdruckquelle bezüglich der Saugspitze 18 ein- oder abzuschalten.

Der Halterahmen 3 besteht aus zwei sich quer zur Bedienungsseite 5 erstreckenden Haltestegen 21,22, von denen der linke Haltesteg 21 starr und der rechte Haltesteg 22 mit einem Führungsstück ann einer sich parallel zur Bedienungsseite 5 erstreckenden Führungsschiene verschiebbar und mittels einer nicht dargestellten Feststellschraube wahlweise feststellbar ist. Die oberen Ränder der Haltestege 21,22 sind einander spiegelbildlich gestuft, so daß sich Auflager für die Leiterplatte 4 und letztere seitlich übergreifende Begrenzungsstege ergeben.

Dem Bestückungskopf 12 ist eine allgemein mit 28 bezeichnete Positioniereinrichtung zugeordnet mit einem Positionierelement 29, das fest mit dem Bestückungskopf 12 verbunden ist, und einem Positionierteil 31, das parallel zur Ebene der Leiterplatte 4 und jeweils in eine der Position des zugehörigen Bestückungsortes entsprechende Positionierstellung verstellbar und in der jeweiligen Positionierstellung feststellbar ist. Beim vorliegenden Ausführungsbeispiel ist das Positionierelement 29 des Bestückungskopfes 12 ein sich von dessen Unterseite parallel zur Saugnadel 17 erstreckender Führungsstift 32. Das Positionierteil 31 der Positioniereinrichtung 28 wird durch eine Leiste 33 mit einem vertikalen Loch 34 im Bereich ihres freien Endes gebildet, das so groß bemessen ist, daß das Paßende des Führungsstifts 32 mit geringem Bewegungsspiel in das Loch 34 einführbar ist. Die Leiste 33 ist höher als die Leiterplatte 4 und die Haltestege 21,22 angeordnet, so daß sie letztere insbesondere beim Vorhandensein großer Leiterplatten 4 zu überfahren vermag.

Die Leiste 33 ist an der Unterseite eines Schiebers 36 befestigt, der an einer sich parallel zur Bedienungsseite 5 erstreckenden Führungsschiene 37 verschiebbar geführt und unterseitig mit der Leiste 33 verbunden ist. Die Führungsschiene 37 ist in der Nähe ihres in der Zeichnung rechten Endes an einem Führungsschlitten 41 befestigt, der quer zur Bedienungsseite 5 an einer weiteren Führungsschiene 42 horizontal verschiebbar ist, die sich zwischen einer vorderen und einer hinteren Seitenwand 43,44 erstreckt und an diesen Seitenwänden 43,44 befestigt ist. Die Seitenwände 43,44 können auf einer auch für die Haltestege 21,22 gemeinsamen Tragplatte befestigt sein und somit ein gemeinsames Traggestell für die Leiterplatte 4 und die Positioniereinrichtung 28 bilden. Das Positionierteil 31 ist somit in zwei rechtwinklig zueinander gerichteten Bewegungsrichtungen A,B (Fig. 2) wahlweise verstellbar, so daß es auf jeden wahlweisen Punkt der Leiterplatte 4 einstellbar ist. Jeder Bewegungsrichtung A,B ist ein eigener Antrieb mit einem Elektromotor 45,46 zugeordnet, der den zugehörigen Führungsschieber 36 bzw. -schlitten 41 mittels eines um Umlenkrollen 47,48 umlaufenden Zahnriemens 49,50 antreibt. Der Elektromotor 45 für den Antrieb des Führungsschlittens 41 in der Bewegungsrichtung A, ist an der Innenseite der Führungsschiene 42 angeordnet und befestigt. Der Elektromotor 46 für den Antrieb des Schiebers 36 in der Bewegungsrichtung B, ist an der Unterseite der Führungsschiene 37 befestigt. Der zugehörige Zahnriementrieb verläuft hier innerhalb der als Hohlschiene ausgebildeten Führungsschiene 37, die eine länglich-runde Querschnittsform aufweist.

Den Elektromotoren 45,46 ist jeweils ein nicht dargestellter Wegmesser zugeordnet, durch den die jeweilige Position des Positionierteils 31 bezüglich einer Ausgangsposition bestimmt ist. Eine solche Ausgangsposition kann abhängig von der Leiterplatte 4 (zunächst Anfahren eines bestimmten Punktes auf der Leiterplatte 4) oder vom zweiten Träger 3 (Positionierung der Leiterplatte 4 bezüglich des Trägers 3) z.B. durch Anschlagkanten. Außerdem sind die Elektromotoren 45,46 mit der elektronischen Steuerschaltung eines nicht dargestellten Computers bzw. Rechners verbunden, der die Bewegungen A,B des Positionierteils 31 steuert, und in dem die Ausgangsposition der Bewegungen A,B und die spezifischen Bestückungsorte der Leiterplatte 4 gespeichert sind. Es ist auch möglich, die Elektromotoren 45,46 mit einer manuellen Steuereinrichtung bzw. Tastatur zu verbinden, so daß unter Berücksichtigung der vorbeschriebenen Ausgangspositionen der Bewegungen A,B beabsichtigte Bestückungsorte auf der Leiterplatte 4 manuell ansteuerbar sind. In jedem Fall wird das Positionierteil 31 jeweils in eine einem Bestückungsort entsprechende Positionierstellung verstellt und in dieser Stellung festgestellt. Dies kann in einfacher Weise durch die Verwendung von Bremsmotoren verwirklicht werden.

Bei dieser Wegsteuerung ist zu berücksichtigen,, daß beim vorliegenden Ausführungsbeispiel die jeweilige Positionierstellung des Positionierteils 31 sich nicht oberhalb des zugehörigen Bestückungsortes befindet, sondern in einem Abstand davon, der in der Wegsteuerung berücksichtigt ist. Da der Abstand a zwischen dem Positionierelement 29 und der Saugnadel 17 dem vorgenannten Abstand entspricht, steht die Saugnadel 17 in jeder angesteuerten Positionierstellung des Positionierteils 31 oberhalb eines zugehörigen Bestückungsortes. Die gegenüber dem zugehörigen Bestückungsort seitlich versetzte Anordnung des Positionierelements 29 und des Positionierteils 31 ist vorteilhaft, da die Sicht auf die Saugspitze 18 der Saugnadel 17 frei bleibt. Es ist im Rahmen der Erfindung jedoch auch möglich, die Positionierstelle des Positionierelements 29 oberhalb des zugehörigen Bestückungsortes anzuordnen und die Saugnadel 18 oder ein Teil derselben als Positionierelement zu benutzen.

Zur vertikalen Stabilisierung des weit auskragenden, die Leiterplatte 4 übergreifenden Endes der Führungsschiene 37, ist dieser eine zusätzliche Führung am Träger 3 zugeordnet. Diese Führung wird durch eine horizontale Nut 20 in der Außenseite der Wand 21 gebildet, in die ein Führungsstück 30 an einem Endstück 40 der Führungsschiene 34 krallenförmig einfaßt.

Zur Bestückung der Leiterplatte 4 mit einem nicht dargestellten Bauelement wird die Saugnadel 17 über ein bestimmtes Fach des Magazins 14 geschoben und durch Zug nach unten am Griff 13 nach unten gezgen, bis die Saugspitze 18 auf ein Bauteil auftrifft und durch Betätigung des Schalters 19 die Saugluft eingeschaltet wird. Dann wird der Bestückungskopf 12 wieder angehoben und durch zunächst horizontale und dann vertikale Bewegung der Führungsstift 32 in das Führungsloch 34 eingeführt. In dieser Position befindet sich die Saugspitze 17 mit dem daran befindlichen Bauelement oberhalb eines zugehörigen Bestückungsortes. Durch weiteres Absenken des Bestückungskopfes 12, wobei der Führungsstift 32 in das Führungsloch 34 weiter eintaucht, trifft das Bauelement auf die Leiterplatte 4 auf, wobei der Schalter 19 wiederum betätigt und die Saugluft abgeschaltet wird. Beim Schalter 19 handelt es sich um einen Wechselschalter, der seine Funktion von Betätigung zu Betätigung wechselt, so daß die Saugluft wechselweise ein- und ausgeschaltet wird.

Es ist je nach Auslegung der Konstruktion möglich, die Saugnadel 18 mittels der Positioniereinrichtung 28 exakt oder ungefähr am Bestückungsort zu positionieren. Die Positionierung ist dann exakt, wenn der Führungsstift 32 etwa schließend in das Führungsloch 34 paßt und der Antrieb insgesamt im wesentlichen spielfrei ausgelegt ist. Einen wesentlichen Spielraum für die Saugnadel 17 im Bereich des zugehörigen Bestückungsortes erhält man dann, wenn der zugehörige Antrieb und/oder die Passung zwischen dem Führungsstift 32 und dem Führungsloch 34 ein merkliches Bewegungsspiel aufweist. Im letzteren Fall läßt sich eine Vorzentrierung verwirklichen, bei der eine individuelle manuelle Nachzentrierung im Bereich des Bestückungsortes möglich ist.

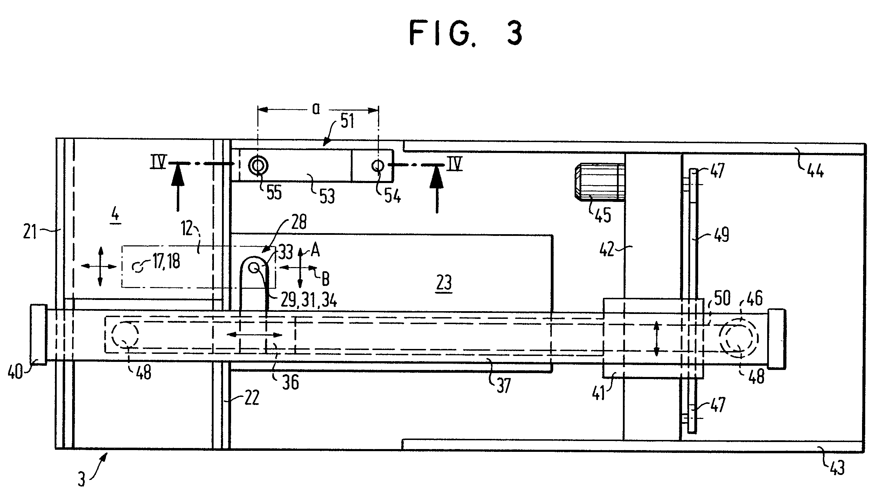

Gemäß Fig. 3 und 4 ist dem Gerät 1 zusätzlich eine Zentriervorrichtung 51 zum Zentrieren eines hier mit 52 bezeichneten Bauelements gegenüber dem Bestückungs - bzw. Haltewerkzeug 16 oder der Saugspitze 18. Die Zentriervorrichtung 51 kann vorteilhaft zwischen dem Magazin 14 und der Leiterplatte 4 oder in der Nähe der Leiterplatte 4 bzw. des Positionierteils 31 angeordnet sein. Beim vorliegenden Ausführungsbeispiel umfaßt die Zentriervorrichtung 51 ein plattenförmiges Zentrierstück 53 mit einem dem Positionierloch 34 entsprechenden Positionierloch 54 und einem davon im Abstand a angeordneten Zentrierloch 55, dessen Querschnitt bzw. Lochwand abwärts konvergiert, und dessen größter Durchmesser größer und dessen kleinster Durchmesser kleiner bemessen ist, als die Länge 1 des vorhandenen Bauelements 52 oder der vorhandenen Bauelemente 52. Beim Absenken des durch den Unterdruck an der Saugspitze 17 gehaltenen Bauelements 52 in das Zentrierloch 55 gerät das betreffende Ende eines exzentrisch gehaltenen Bauelements 52 in Kontakt mit der geneigtenLochwand 56, wobei das Bauelement 52 automatisch in die zentrische Position verschoben wird. Die Anordnung ist dabei so getroffen, daß das untere Bewegungsende des Bestückungskopfes 12 erreicht wird, bevor das Bauelement 52 mit beiden Enden die Lochwand 56 berührt und somit festklemmen bzw. den Schalter 19 auslösen könnte. Folglich kann das Bauelement 52 nach diesem Zentrierhub an einer Zwischenposition bei Haftung an der Saugspitze 17 wieder aus dem Zentrierloch 55 gehoben und zur Leiterplatte 4 weitertransportiert werden. Beim vorliegenden Ausführungsbeispiel ist das Zentrierstück 53 von der Bedienungsseite 5 aus gesehen hinte dem Positionierteil 31 angeordnet und zwar vorzugsweise höhenverstellbar am vorhandenen die Positioniereinrichtung 28 und die Leiterplatte 4 tragenden Gestell, hier an der Wand 22. Vorzugsweise ist das Positionierloch 54 höher angeordnet als das Zentrierloch 55 um zum einen eine Spitze für den Führungsstift 32 verwirklichen zu können und zum anderen diese Spitze nicht tiefer anzuordnen als die Saugspitze 18.

## Patentansprüche

1. Gerät (1) zum Bestücken und/oder Verlöten bzw. Verkleben von elektronischen Bauelementen, insbesondere SMD-Bauelementen, auf Leiterplatten (4),
mit einem ersten Träger (3) für wenigstens eine Leiterplatte (4) und einem zweiten Träger (12, 18) für das Bauelement (52), wobei der zweite Träger (12, 18) gegenüber dem ersten Träger (3) parallel zur Ebne der Leiterplatte (4) und quer dazu verstellbar ist,
mit einem Magazin (14) für die Bauelemente,
wobei dem zweiten Träger (12) eine Positioniereinrichtung (28) zugeordnet ist, mit einem Positionierteil (31), das sich in einer dem Bestückungsort entsprechenden Position befindet,
und mit einem Positionierelement (29) am zweiten Träger (12), das mit dem Positionierteil (31) in Wirkverbindung bringbar ist zur Positionierung des zweiten Trägers (12) bezüglich seiner Bewegung parallel zur Ebene der Leiterplatte (4),
**dadurch gekennzeichnet,**
daß das Positionierteil (31) parallel zur Ebene der Leiterplatte (4) in eine oder mehrere, zugehörigen Bestückungsorten entsprechende Positionen verstellbar und in der jerweiligen Verstellposition feststellbar ist.

2. Gerät nach Anspruch 1,
dadurch gekennzeichnet,
daß das Positionierelement (29) durch eine quer zur Ebene der Leiterplatte (4) gerichtete Bewegung in Wirkverbindung mit dem Positionierteil (31) bringbar ist.

3. Gerät nach Anspruch 2,
dadurch gekennzeichnet,
daß während der Wirkverbindung zwischen dem Positionierelement (29) und dem Positionierteil (31) das Positionierelement (29) gegenüber dem Positionierteil (31) quer zur Ebene der Leiterplatte (4) verstellbar ist.

4. Gerät nach einem der Ansprüche 1 bis 3,
dadurch gekennzeichnet,
daß das Positionierelement (29) und das Positionierteil (31) miteinander in Wirkverbindung bringbare Führungsteile sind.

5. Gerät nach Anspruch 4,
dadurch gekennzeichnet,
daß das Positionierelement (29) ein Führungsstift (32) und das Positionierteil (31) ein Führungsteil (31) mit einem an den Querschnitt des Führungsstiftes (32) angepaßten Führungsloch (34) ist.

6. Gerät nach Anspruch 5,
dadurch gekennzeichnet,
daß der Führungsstift (32) an seinem freien Ende konisch verjüngt oder kugelförmig ist.

7. Gerät nach Anspruch 5 oder 6,
dadurch gekennzeichnet,
daß der zweite Träger (17,18) an einem vertikal verstellbaren Bestückungskopf (12) angeordnet ist,
und daß auch der Führungsstift (32) am Bestückungskopf (12) angeordnet ist, und sich parallel zur Achse des zweiten Trägers (17, 18) erstreckt.

8. Gerät nach einem der Ansprüche 5 bis 7,
dadurch gekennzeichnet,
daß der Führungsstift (32) in einem horizontalen Abstand (a) vom zweiten Träger (17,18) angeordnet ist.

9. Gerät nach Anspruch 7 oder 8,
dadurch gekennzeichnet,
daß der zweite Träger (17,18) eine Saugnadel ist.

10. Gerät nach einem der Ansprüche 5 bis 9,
dadurch gekennzeichnet,
daß das Führungsteil (31) in zwei rechtwinklig zueinander gerichteten Bewegungsrichtungen (A,B) verstellbar ist, vorzugsweise parallel zur Bedienungsseite (5) und quer dazu.

11. Gerät nach Anspruch 10,
**dadurch gekennzeichnet,**
daß das Positionierteil (31) mit einem Schieber (36) verbunden ist, der längs einer sich parallel zur Bedienungsseite erstreckenden Führungsschiene (37) verschiebbar geführt ist.

12. Gerät nach Anspruch 11,
**dadurch gekennzeichnet,**
daß das Positionierteil (31) ein vom Schieber (36) vorzugsweise zur Rückseite des Gerätes (1) vorspringender Ansatz (33) ist.

13. Gerät nach Anspruch 11 oder 12,
dadurch gekennzeichnet,
daß die Führungsschiene (37) an einem Führungsschlitten (41) gehalten ist, der quer zur Bedienungsseite (5) des Geräts (1) an einer weiteren Führungsschiene (42) verschiebbar geführt ist.

14. Gerät nach Anspruch 13,
dadurch gekennzeichnet,
daß die weitere Führungsschiene (42) am ersten Träger (3) für die Leiterplatte (4) gehalten ist.

15. Gerät nach Anspruch 14,
dadurch gekennzeichnet,
daß die weitere Führungsschiene (42) an zwei sich parallel zueinander erstreckenden vertikalen Wandteilen (43,44) befestigt ist, die auf einer Grundplatte des ersten Trägers (3) befestigt sind.

16. Gerät nach einem der Ansprüche 11 bis 15,
dadurch gekennzeichnet,
daß die Führungsschiene (37) sich mit einem Ende über die Leiterplatte (4) hinaus erstreckt und an diesem Ende horizontal in einer zusätzlichen Führung geführt ist.

17. Gerät nach einem der Ansprüche 11 bis 16,
dadurch gekennzeichnet,
daß dem Schieber (36) und dem Führungsschlitten (41) jeweils ein Elektromotor (45,46) zugeordnet ist, der vorzugsweise mittels eines Zahnriementriebs (47,48) den Schieber (36) bzw. den Führungsschlitten (41) antreibt.

18. Gerät nach wenigstens einem der Ansprüche 1 bis 17, dadurch gekennzeichnet, daß der zweite Träger (17, 18) durch eine Saugnadel (18) gebildet ist, und
daß dem Gerät eine Zentriervorrichtung (51) mit einem konvergierenden Zentrierloch (54) in einem Zentrierstück (53) zugeordnet ist, daß der größte Querschnitt des Zentrierlochs (55) größer und der kleinste Qurschnitt kleiner als das Bauelement (52) ist, und daß die Saugnadel (18) in einer mit dem Zentrierloch (55) konzentrischen Position zentrierbar ist.

19. Gerät nach Anspruch 18,
dadurch gekennzeichnet,
daß in einem Abstand (a) von der Saugnadel (18) ein stiftförmiges Positionierelement (29,32) am die Saugnadel (18) tragenden Bestückungskopf (12) angeordnet ist und im Zentrierstück (53) in einem Abstand (a) vom Zentrierloch (55) ein Positionierloch (54) vorhanden ist, dessen Querschnitt dem Querschnitt des Positionierelementes angepaßt ist.

20. Gerät nach Anspruch 18 oder 19,
dadurch gekennzeichnet,
daß das Zentrierloch (55) höher angeordnet ist als die Leiterplatte (4).

21. Gerät nach einem der vorherigen Ansprüche,
dadurch gekennzeichnet,
daß das Positionierelement (29,32) an seinem freien Ende konisch konvergiert oder gerundet ist und vorzugsweise das Positionierloch (54) höher angeordnet ist als das Zentrierloch (55).

## Claims

1. Apparatus (1) for mounting and/or soldering or cementing electronic components, in particular SMD components, on circuit boards (4),
having a first carrier (3) for at least one circuit board (4) and a second carrier (12, 18) for the component (52), the second carrier (12, 18) being displaceable relative to the first carrier (3) parallel to the plane of the circuit board (4) and transverse thereto,
having a magazine (14) for the components,
the second carrier (12) having associated therewith a positioning device (28) with a positioning part (31) which is located in a position corresponding to the mounting point,
and having a positioning element (29) on the second carrier (12) that can be brought into operative connection with the positioning part (31) to position the second carrier (12) with respect to its movement parallel to the plane of the circuit board (4),
characterised in that,
the positioning part (31) is displaceable parallel to the plane of the circuit board (4) into positions corresponding to one or more associated mounting points, and is fixable in each respective displaced position.

2. Apparatus according to claim 1,
characterised in that,
the positioning element (29) can be brought into operative connection with the positioning part (31) by a movement transverse to the plane of the circuit board (4).

3. Apparatus according to claim 2,
characterised in that,
during the operative connection between the positioning element (29) and the positioning part (31) the positioning element (29) can be displaced relative to the positioning part (31) transverse to the plane of the circuit board (4).

4. Apparatus according to any of claims 1 to 3,
characterised in that,
the positioning element (29) and the positioning part (31) are guide parts that can be brought into operative connection with one another.

5. Apparatus according to claim 4,
characterised in that,
the positioning element (29) is a guide pin (32) and the positioning part (31) is a guide part (31) having a guide hole (34) adapted to the cross-section of the guide pin (32).

6. Apparatus according to claim 5,
characterised in that,
the guide pin (32) is conically tapered or spherically formed at its free end.

7. Apparatus according to claim 5 or 6,
characterised in that,
the second carrier (17, 18) is arranged on a vertically displaceable mounting head (12), and in that the guide pin (32) is also arranged on the mounting head (12) and extends parallel to the axis of the second carrier (17, 18).

8. Apparatus according to any of claims 5 to 7,
characterised in that,
the guide pin (32) is arranged spaced at a horizontal distance (a) from the second carrier (17, 18).

9. Apparatus according to claim 7 or 8,
characterised in that,
the second carrier (17, 18) is a suction needle.

10. Apparatus according to any of claims 5 to 9,
characterised in that,
the guide part (31) is displaceable in two directions of movement (A, B) directed at right-angles to one another, preferably parallel to the operator side (5) and transverse thereto.

11. Apparatus according to claim 10,
characterised in that,
the positioning part (31) is attached to a slide (36), which is slidably guided along a guide rail (37) extending parallel to the operator side.

12. Apparatus according to claim 11,
characterised in that,
the positioning part (31) is an attachment (33) projecting from the slide (36) preferably towards the rear of the apparatus (1).

13. Apparatus according to claim 11 or 12,
characterised in that,
the guide rail (37) is held on a guide carriage (41) that is slidably guided transverse to the operator side (5) of the apparatus (1) on a further guide rail (42).

14. Apparatus according to claim 13,
characterised in that,
the further guide rail (42) is held on the first carrier (3) for the circuit board (4).

15. Apparatus according to claim 14,
characterised in that,
the further guide rail (42) is fastened to two vertical wall parts (43, 44) that extend parallel to one another and are fastened to a base plate of the first carrier (3).

16. Apparatus according to any of claims 11 to 15,
characterised in that,
the guide rail (37) extends with one end beyond the circuit board (4) and this end is horizontally guided in an additional guide.

17. Apparatus according to any of claims 11 to 16,
characterised in that,
respective electric motors (45, 46) are associated with the slide (36) and the guide carriage (41) which - preferably by means of a toothed belt drive (47, 48) - drive the slide (36) and the guide carriage (41).

18. Apparatus according to any of claims 1 to 17,
characterised in that,
the second carrier (17,18) is formed by a suction needle (18), and
in that the apparatus has associated with it a centering device (51) with a converging centering hole (54) in a centering part (53), in that the largest cross-section of the centering hole (55) is larger and the smallest cross-section is smaller than the component (52), and in that the suction needle (18) can be centered in a position concentric with the centering hole (55).

19. Apparatus according to claim 18,
characterised in that,
a pin-shaped positioning element (29, 32) is arranged on the mounting head (12) carrying the suction needle (18), at a spacing (a) from the suction needle (18), and a positioning hole (54) is present in the centering piece (53) at a spacing (a) from the centering hole (55), the cross-section of the positioning hole being adapted to the cross-section of the positioning element.

20. Apparatus according to claim 18 or 19,
characterised in that,
the centering hole (55) is arranged higher than the circuit board (4).

21. Apparatus according to any preceding claim,
characterised in that,
at its free end the positioning element (29, 32) converges conically or is rounded and preferably the positioning hole (54) is arranged higher than the centering hole (55).

## Revendications

1. Dispositif de montage et/ou de soudage ou collage de composants électroniques, en particulier de composants SMD sur des plaques de circuits (4), comprenant
un premier support (3) pour au moins une plaque de circuits imprimés (4) et un deuxième support (12, 18) pour le composant (52), le deuxième support (12, 18) étant déplaçable par rapport au premier support (3) parallèlement au plan de la plaque de circuits imprimés (4) et transversalement à ce plan,
un magasin (14) pour les composants,
un dispositif de positionnement (28) associé au deuxième support (12) et comprenant une partie de positionnement (31) qui se trouve dans une position correspondant à l'emplacement de montage, et
un élément de positionnement (29) prévu sur le deuxième support (12) et pouvant être amené en liaison active avec la partie de positionnement (31) en vue du positionnement du deuxième support (12) en ce qui concerne son mouvement parallèlement au plan de la plaque de circuits imprimés (4),
caractérisé par le fait
que la partie de positionnement (31) est déplaçable parallèlement au plan de la plaque de circuits imprimés (4) dans une ou plusieurs positions correspondant aux lieus de montage associés, et peut être immobilisée dans la position de déplacement respective.

2. Dispositif suivant la revendication 1,
caractérisé par le fait
que l'élément de positionnement (29) peut être amené en liaison active avec la partie de positionnement (31) par un mouvement transversalement au plan de la plaque de circuits imprimés (4).

3. Dispositif suivant la revendication 2,
caractérisé par le fait
que pendant la liaison active entre l'élément de positionnement (29) et la partie de positionnement (31), l'élément de positionnement (29) est déplaçable par rapport à la partie de positionnement (31) transversalement au plan de la plaque de circuits imprimés (4).

4. Dispositif suivant l'une des revendications 1 à 3,
caractérisé par le fait
que l'élément de positionnement (29) et la partie de positionnement (31) sont des parties de guidage pouvant être amenées en liaison active l'une avec l'autre.

5. Dispositif suivant la revendication 4,
caractérisé par le fait
que l'élément de positionnement (29) est une broche de positionnement (32) et la partie de positionnement (31) une partie de guidage (31) avec un trou de guidage (34) adapté à la section de la broche de guidage (32).

6. Dispositif suivant la revendication 5,
caractérisé par le fait
que la broche de guidage (32) est effilée de façon conique ou sphérique à son extrémité libre.

7. Dispositif suivant la revendication 5 ou 6,
caractérisé par le fait
que le deuxième support (17, 18) est disposé sur une tête de montage (12) déplaçable verticalement et que la broche de guidage (32) est également disposée sur la tête de montage (12) et s'étend parallèlement à l'axe du deuxième support (12).

8. Dispositif suivant l'une des revendications 5 à 7,
caractérisé par le fait
que la broche de guidage (32) est disposée à une distance horizontale (a) du deuxième support (17, 18).

9. Dispositif suivant la revendication 7 ou 8,
caractérisé par le fait
que le deuxième support (17, 18) est une aiguille à ventouse.

10. Dispositif suivant l'une des revendications 6 à 9,
caractérisé par le fait
que la partie de guidage (32) est déplaçable dans deux directions de mouvement (A, B) perpandiculaires l'une par rapport à l'autre, de préférence parallèlement au côté de commande (5) et transversalement à ce côté.

11. Dispositif suivant la revendication 10,
caractérisé par le fait
que la partie de positionnement (31) est reliée à un coulisseau (36) qui est guidé déplaçable en translation le long d'un rail de guidage (37) s'étendant parallèlement au côté de commande.

12. Dispositif suivant la revendication 11,
caractérisé par le fait
que la partie de positionnement (31) est une saillie (33) dépassant du coulisseau (36), de préférence vers le côté arrière du dispositif (1).

13. Dispositif suivant la revendication 11 ou 12,
caractérisé par le fait
que le rail de guidage (37) est maintenu sur un chariot de guidage (41) qui est guidé mobile en translation perpendiculairement au côté de commande (5) du dispositif (1) sur un autre rail de guidage (42).

14. Dispositif suivant la revendication 13,
caractérisé par le fait
que l'autre rail de guidage (42) est maintenu sur le premier support (3) pour la plaque de circuits imprimés (4).

15. Dispositif suivant la revendications 14,
caractérisé par le fait
que l'autre rail de guidage (42) est fixé à deux parties de paroi (43, 44) verticales, s'étendant parallèlement l'une à l'autre et fixées sur une plaque de base du premier support (3).

16. Dispositif suivant l'une des revendications 11 à 15,
caractérisé par le fait
que le rail de guidage (37) s'étend, avec une extrémité, au-delà de la plaque de circuits imprimés (4) et est guidé à cette extrémité horizontalement dans un guide supplémentaire.

17. Dispositif suivant l'une des revendications 11 à 16,
caractérisé par le fait
que deux moteurs électriques (45, 46) sont associés l'un au coulisseau (36) et l'autre au chariot de guidage (41) pour entraîner le coulisseau (36) et le chariot de guidage (41) de préférence au moyen d'une transmission à courroie crantée (47, 48).

18. Dispositif suivant au moins l'une des revendications 1 à 17,
caractérisé par le fait
que le deuxième support (12, 18) est constitué par une aiguille à ventouse (18) et qu'un système de centrage (51) avec un trou de centrage (54) convergent dans une première pièce de centrage (53) est associé au dispositif, que la plus grande section du trou de centrage (55) est plus grande et que la plus petite section est plus petite que le composant (52), et que l'aiguille à ventouse (18) peut être centrée dans une position concentrique avec le trou de centrage (55).

19. Dispositif suivant la revendication 18,
caractérisé par le fait
qu'un élément de positionnement (29, 32) en forme de tige est disposé sur la tête de montage (12) portant l'aiguille à ventouse (18), à une distance (a) de l'aiguille à ventouse (18), et qu'un trou de positionnement (54) dont la section est adaptée à la section de l'élément de positionnement est prévu dans la pièce de centrage (53) à une distance (a) du trou de centrage (55).

20. Dispositif suivant la revendication 18 ou 19,
caractérisé par le fait
que le trou de centrage (55) est disposé plus haut que la plaque de circuits imprimés (4).

21. Dispositif suivant l'une des revendications précédentes,
caractérisé par le fait
que l'élément de positionnement (29, 32) converge en cône ou est arrondi à son extrémité libre et que de préférence le trou de positionnement (54) est disposé plus haut que le trou de centrage (55).
